# EUROPEAN PATENT APPLICATION

(11) **EP 4 718 991 A1**
(43) Date of publication of application: **01.04.2026**
(21) Application number: 25192095.5
(22) Date of filing: 28.07.2025
(51) Int. Cl.: H10D 84/01, H10D 30/00, H10D 62/13, H10D 84/83

(54) **SEMICONDUCTOR DEVICE**

(30) Priority: 25.09.2024 KR 20240129632
(71) Applicant: Samsung Electronics Co., Ltd., Suwon-si, Gyeonggi-do 16677 (KR)
(72) Inventor: LEE, Jimyoung, 16677 Suwon-si, Gyeonggi-do (KR); LEE, Kwangyoung, 16677 Suwon-si, Gyeonggi-do (KR); HONG, Seki, 16677 Suwon-si, Gyeonggi-do (KR)
(74) Representative: Kuhnen & Wacker Patent- und Rechtsanwaltsbüro PartG mbB

(57) **Abstract**

A semiconductor device may include a first active pattern (105a) extending in a first direction (X) and having a first width (W1a) in a second direction (Y), a second active pattern (105b) extending in the first direction (X) and having a second width in the second direction (Y) that is less than the first width (W1a), first gate structures (160a) extending on the first active pattern (105a), second gate structures (160b) extending on the second active pattern (105b), a first source/drain region (150a) on the first active pattern (105a) between the first gate structures (160a), a second source/drain region (150b) on the second active pattern (105b) between the second gate structures (160b), a first fin spacer (155a) on a side surface of the first source/drain region (150a), and a second fin spacer (155b) on a side surface of the second source/drain region (150b). A height of the first fin spacer (155a) in a third direction (Z) may be less than a height of the second fin spacer (155b) in the third direction (Z).

## Description

### BACKGROUND OF THE INVENTION

The present inventive concepts relate to a semiconductor device. In particular, the present inventive concepts relate to a three-dimensional (3D) semiconductor device including a field-effect transistor (FET).

As demand for high performance, high speed, and/or multifunctionality of semiconductor devices increases, a degree of integration of the semiconductor devices is also increasing. In manufacturing a semiconductor device having a fine pattern corresponding to the trend of such a high degree of integration of the semiconductor devices, it is helpful to implement patterns having a fine width or a fine separation distance. In addition, efforts are being made to develop a semiconductor device including a FinFET having a three-dimensional channel in order to overcome limitations of operating characteristics due to a decrease in size of a planar metal-oxide-semiconductor FET (MOSFET).

### SUMMARY OF THE INVENTION

Aspects of the present inventive concepts provide a semiconductor device having improved reliability and electrical characteristics.

However, aspects of the present inventive concepts are not limited to the above-described aspects, and may be variously expanded within the scope of the present inventive concepts.

According to some aspects of the present inventive concepts, a semiconductor device may comprise a substrate that includes a first active pattern extending in a first direction and having a first width in a second direction intersecting the first direction, and a second active pattern extending in the first direction and having a second width in the second direction that is less than the first width; first gate structures spaced apart from each other in the first direction and extending in the second direction on the first active pattern; second gate structures spaced apart from each other in the first direction and extending in the second direction on the second active pattern; a first source/drain region on the first active pattern between the first gate structures; a second source/drain region on the second active pattern between the second gate structures; a first fin spacer on a side surface of the first source/drain region; and a second fin spacer on a side surface of the second source/drain region, wherein a height of the first fin spacer in a third direction intersecting the first and second directions is less than a height of the second fin spacer in the third direction.

According to some aspects of the present inventive concepts, a semiconductor device may comprise a substrate; a first active pattern extending in a first direction on the substrate and having a first width in a second direction intersecting the first direction; a second active pattern extending in the first direction on the substrate and having a second width in the second direction that is less than the first width; first gate structures extending in the second direction on the first active pattern; second gate structures extending in the second direction on the second active pattern; a first source/drain region on the first active pattern between the first gate structures; and a second source/drain region on the second active pattern between the second gate structures, wherein the first source/drain region includes a first extension portion contacting an upper surface of the first active pattern, and a first expansion portion extending from the first extension portion, the first expansion portion having a width in the second direction that increases and then decreases when moving away from the substrate in a third direction intersecting the first and second directions, wherein the second source/drain region includes a second extension portion contacting an upper surface of the second active pattern, and a second expansion portion extending from the second extension portion, the second expansion portion having a width in the second direction that increases and then decreases when moving away from the substrate in the third direction, and wherein a height of the first extension portion in the third direction is less than a height of the second extension portion in the third direction.

According to some aspects of the present inventive concepts, a semiconductor device may comprise a substrate that includes a first active pattern extending in a first direction and having a first width in a second direction intersecting the first direction, and a second active pattern extending in the first direction and having a second width in the second direction that is less than the first width; a device isolation layer on the substrate and on opposite side surfaces of the first active pattern and opposite side surfaces of the second active pattern; first gate structures spaced apart from each other in the first direction and extending in the second direction on the first active pattern; second gate structures spaced apart from each other in the first direction and extending in the second direction on the second active pattern; first fin spacers on the device isolation layer between the first gate structures; second fin spacers on the device isolation layer between the second gate structures; a first source/drain region on the first active pattern between the first fin spacers; and a second source/drain region on the second active pattern between the second fin spacers, wherein a width of each of the first gate structures in the first direction is equal to a width of each of the second gate structures in the first direction, wherein opposite side surfaces of a first portion of the first source/drain region in the second direction are free of the first fin spacers thereon, and opposite side surfaces of a second portion of the second source/drain region in the second direction are free of the second fin spacers thereon, and wherein a cross-sectional area of the first portion of the first source/drain region is greater than a cross-sectional area of the second portion of the second source/drain region, when viewed along the second direction.

### BRIEF DESCRIPTION OF DRAWINGS

The above and other aspects, features, and advantages of the present inventive concepts will be more clearly understood from the following detailed description, taken in conjunction with the accompanying drawings, in which:
FIG. 1 is a plan view illustrating a semiconductor device according to embodiments.
FIG. 2 is a cross-sectional view taken along lines Ia-Ia' and Ib-Ib' of FIG. 1.
FIG. 3 is a cross-sectional view taken along lines IIa-IIa' and IIb-IIb' of FIG. 1.
FIG. 4A is a cross-sectional view taken along lines IIIa-IIIa' and IIIb-IIIb' of FIG. 1.
FIGS. 4B, 4C, and 4D are cross-sectional views taken along lines IIIa-IIIa' and IIIb-IIIb' of FIG. 1 according to further embodiments.
FIGS. 5A and 5B are views illustrating electrical characteristics according to a width of an active pattern of a semiconductor device and a width of an active pattern of a reference semiconductor device.
FIGS. 6A, 6B, 7, 8A, 8B, 9A, 9B, 9C, 10A, 10B, 11, and 12 are views illustrating a process sequence for a method of manufacturing a semiconductor device according to embodiments.

### DETAILED DESCRIPTION

Hereinafter, with reference to the attached drawings, example embodiments will be described in more detail. The same reference numerals may be used for the same components in the drawings, and duplicate descriptions of the same components may be omitted.

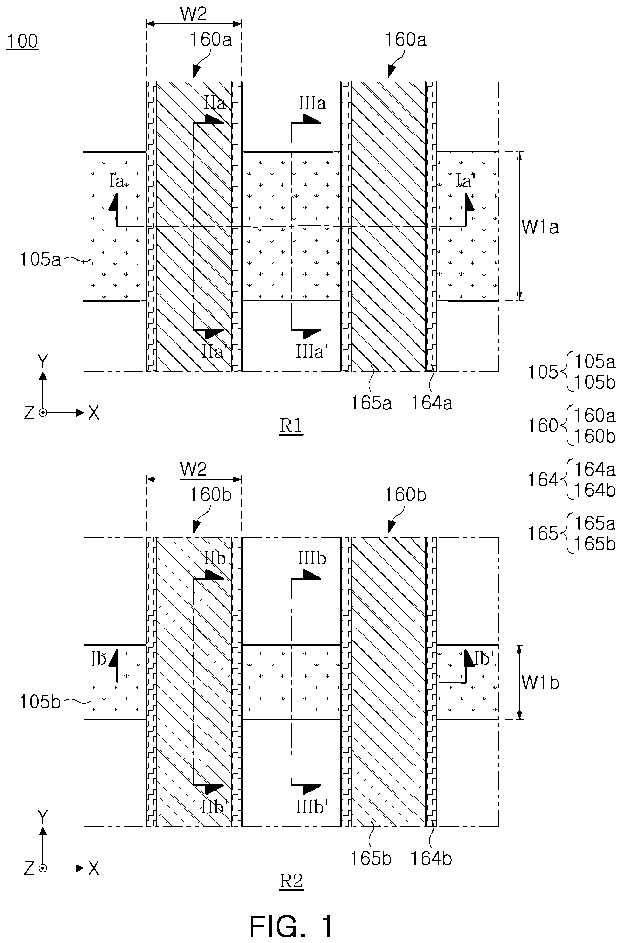

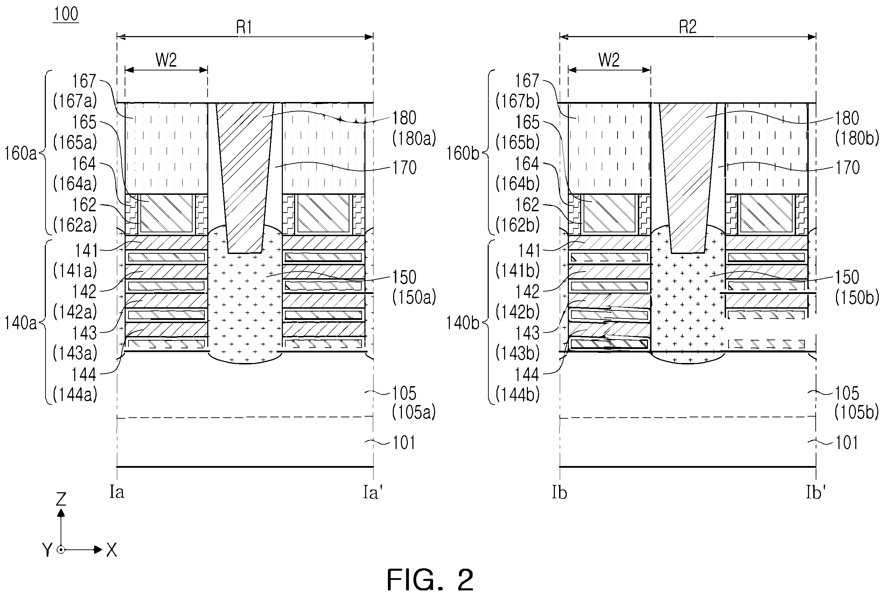

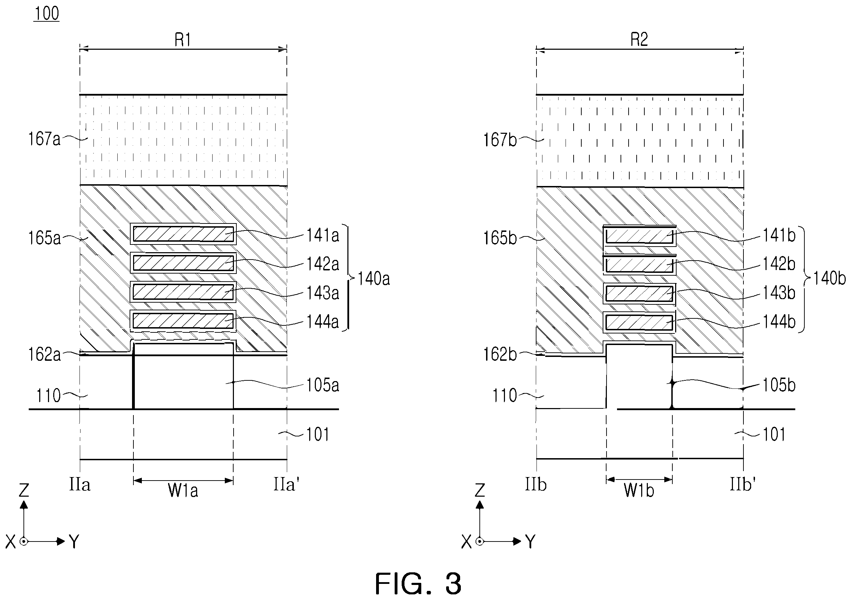

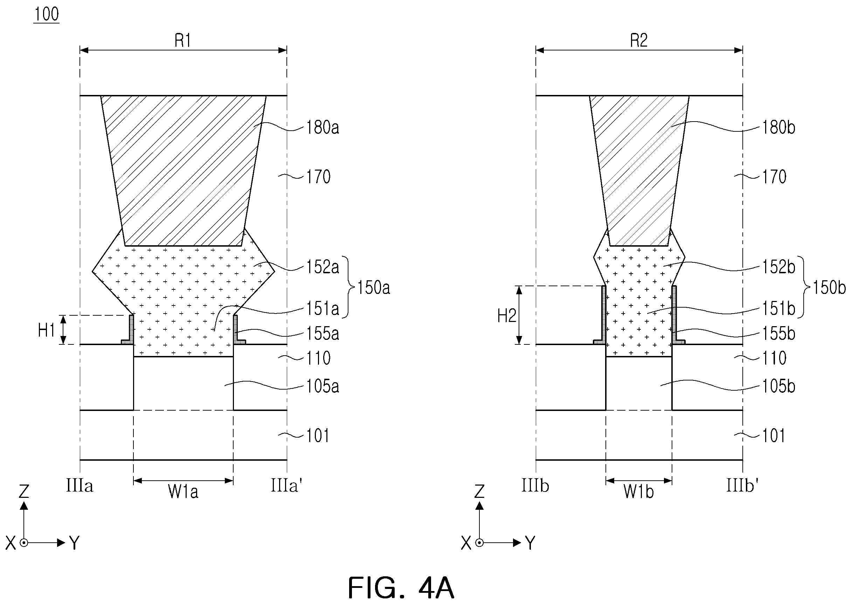

FIG. 1 is a plan view illustrating a semiconductor device according to embodiments. FIG. 2 is a cross-sectional view taken along lines Ia-Ia' and Ib-Ib' of FIG. 1. FIG. 3 is a cross-sectional view taken along lines IIa-IIa' and IIb-IIb' of FIG. 1. FIG. 4A is a cross-sectional view taken along lines IIIa-IIIa' and IIIb-IIIb' of FIG. 1. For convenience of explanation, only some components of a semiconductor device may be illustrated in FIG. 1. Cross-sectional views illustrating embodiments of a semiconductor device 100 taken along lines Ia-Ia' and Ib-Ib' may have the same structure.

Referring to FIGS. 1, 2, 3, and 4A, a semiconductor device 100 may include a first region R1 and a second region R2. The first region R1 and the second region R2 may be spaced apart in a first direction (X-direction). In some embodiments, the first region R1 and the second region R2 may be disposed side by side in the first direction (X-direction) (i.e., may be adjacent to each other in the first direction (X-direction)). The first region R1 may be referred to as a region having a first active pattern 105a having a first width W1a, and a region in which a wide nanosheet transistor is disposed. The second region R2 may be referred to as a region having a second active pattern 105b having a second width W1b, smaller than (i.e., less than) the first width W1a, and a region in which a narrow nanosheet transistor is disposed. As used herein, components may be individually referred to by their respective reference numerals and may be collectively referred to by the shared parts of their reference numerals. For example, the first active pattern 105a and the second active pattern 105b may be collectively referred to as active patterns 105.

The semiconductor device 100 may include a substrate 101 including active patterns 105, channel structures 140 including first to fourth channel layers 141, 142, 143, and 144 disposed vertically (e.g., in a third direction (Z-direction)) and spaced apart from each other on the active patterns 105, gate structures 160 extending across the active patterns 105 and respectively including a gate electrode 165, source/drain regions 150 contacting the channel structures 140, first fin spacers 155a disposed on both (i.e., opposite) sidewalls (i.e., side surfaces) of a first source/drain region 150a of the source/drain regions 150, second fin spacers 155b disposed on both sidewalls of a second source/drain region 150b of the source/drain regions 150, and contact plugs 180 connected to the source/drain regions 150. The semiconductor device 100 may further include a device isolation layer 110 and an interlayer insulating layer 170.

In the semiconductor device 100, each of the active patterns 105 may have a fin structure, and gate electrodes 165 may be disposed between the active patterns 105 and the channel structures 140, between the first to fourth channel layers 141, 142, 143, and 144 of each of the channel structures 140, and on the channel structure 140. Therefore, the semiconductor device 100 may include transistors having a multi-bridge channel FET (MBCFET^{™}) structure, which may be a gate-all-around (GAA) type field-effect transistor.

The substrate 101 may have an upper surface extending in a first direction (X-direction) and a second direction (Y-direction). The substrate 101 may include a semiconductor material, such as a group IV semiconductor, a group III-V compound semiconductor, or a group II-VI compound semiconductor. For example, the group IV semiconductor may include silicon, germanium, or silicon-germanium. The substrate 101 may be provided as a bulk wafer, an epitaxial layer, a silicon-on-insulator (SOI) layer, a semiconductor-on-insulator (SeOI) layer, or the like.

The substrate 101 may include the active patterns 105 disposed in an upper portion of the substrate 101. The active patterns 105 may be defined by the device isolation layer 110 in the substrate 101, and may be disposed to extend in the first direction (X-direction). Depending on a description manner, it is possible to describe the active patterns 105 as a separate configuration from the substrate 101. As used herein, it will be understood that the active patterns 105 may be considered as part of the substrate 101 or as separate from the substrate 101, without departing from the scope of the present disclosure. The active patterns 105 may partially protrude above the device isolation layer 110, so that an upper surface of the active patterns 105 may be located on a level, higher than a level of an upper surface of the device isolation layer 110. As used herein, the term "level" may indicate a distance above or relative to the substrate 101 (e.g., an upper surface of the substrate 101) in a vertical direction (e.g., a third direction (Z-direction)), unless otherwise noted. The active patterns 105 may be formed as a portion of the substrate 101 or may include an epitaxial layer grown from the substrate 101. At both sides of the gate structures 160, the active patterns 105 may be partially recessed to form recessed regions, and the source/drain regions 150 may be disposed in the recessed regions.

The active patterns 105 may include a first active pattern 105a disposed in a first region R1 and a second active pattern 105b disposed in a second region R2. The first active pattern 105a may have a first width W1a in the second direction (Y-direction), and the second active pattern 105b may have a second width W1b, smaller than the first width W1a, in the second direction (Y-direction). For example, the first width W1a may have a size two to three times that of the second width W1b. Each of the first active pattern 105a and the second active pattern 105b may extend in the first direction (X-direction). The first active pattern 105a and the second active pattern 105b may be disposed side by side in the first direction (X-direction). In another example, the first active pattern 105a and the second active pattern 105b may be spaced apart in the second direction (Y-direction).

Each of the first active pattern 105a and the second active pattern 105b may or may not include a well region including impurities. For example, in an N-type transistor (e.g., an nFET), the well region may include P-type impurities such as boron (B), gallium (Ga), or indium (In). In a P-type transistor (e.g., a pFET), the well region may include N-type impurities such as phosphorus (P), arsenic (As), or antimony (Sb), and the well region may be located at a predetermined depth from an upper surface of the first active pattern 105a and an upper surface of the second active pattern 105b, for example.

The device isolation layer 110 may define the active patterns 105 within the substrate 101. The device isolation layer 110 may be formed, for example, by a shallow trench isolation (STI) process. The device isolation layer 110 may expose an upper surface of the active pattern 105, and may also expose a portion of an upper portion of the active pattern 105. In some embodiments, the device isolation layer 110 may have a curved upper surface such that a level thereof is higher toward the active pattern 105. The device isolation layer 110 may be formed of an insulating material. The device isolation layer 110 may include, for example, an oxide, a nitride, or a combination thereof. The device isolation layer 110 may be on (e.g., may cover and/or overlap) both sidewalls of the first active pattern 105a and both sidewalls of the second active pattern 105b. As used herein, "an element A overlaps an element B in a direction X" (or similar language) means that there is at least one straight line that extends in the direction X and intersects both the elements A and B.

The gate structures 160 may be disposed on the active patterns 105 and the channel structures 140 to extend in the second direction (Y-direction) while intersecting the active patterns 105 and the channel structures 140. The gate structures 160 may include first gate structures 160a spaced apart from each other in the first direction (X-direction) in the first region R1 and extending in the second direction (Y-direction), and second gate structures 160b spaced apart from each other in the first direction (X-direction) in the second region R2 and extending in the second direction (Y-direction).

The first gate structures 160a may be spaced apart from each other in the first direction (X-direction), and may extend in the second direction (Y-direction) in the first region R1, and the second gate structures 160b may be spaced apart from each other in the first direction (X-direction), and may extend in the second direction (Y-direction) in the second region R2. In some embodiments, the first gate structures 160a and the second gate structures 160b may have a third width W2 in the first direction (X-direction). For example, a width of each of the first gate structures 160a in the first direction (X-direction) may be equal to a width of each of the second gate structures 160b in the first direction (X-direction). In some embodiments, a first separation distance between the first gate structures 160a (e.g., in the first direction (X-direction)) may be substantially equal to a second separation distance between the second gate structures 160b (e.g., in the first direction (X-direction)).

The active patterns 105 and/or the channel structures 140 may form functional channel regions of transistors. Each of the gate structures 160 may include a gate electrode 165, gate dielectric layers 162 between the gate electrode 165 and the first to fourth channel layers 141, 142, 143, and 144, a gate spacer layer 164 on side surfaces of the gate electrode 165, and a gate capping layer 167 extending in the second direction (Y-direction) on the gate electrode 165.

The gate dielectric layers 162 may be disposed between the active patterns 105 and the gate electrodes 165, and between the channel structures 140 and the gate electrodes 165, and may be disposed to be on (e.g., to cover and/or overlap) at least a portion of surfaces of the gate electrodes 165. For example, the gate dielectric layers 162 may be disposed to be on (e.g., to surround) all surfaces of the gate electrode 165, except the uppermost surface of the gate electrode 165. The gate dielectric layers 162 may extend between the gate electrodes 165 and the gate spacer layers 164, but are not limited thereto. The gate dielectric layers 162 may include an oxide, a nitride, or a high-κ material. The high-κ material may mean a dielectric material having a higher dielectric constant than silicon oxide (SiO₂). The high-κ material may be, for example, at least one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), or praseodymium oxide (Pr₂O₃). According to some embodiments, the gate dielectric layer 162 may be formed as a multilayer film.

The gate electrodes 165 may be disposed to be in (e.g., to fill) gaps between the first to fourth channel layers 141, 142, 143, and 144 on the active patterns 105, and may extend onto the channel structures 140. The gate electrodes 165 may be separated from the first to fourth channel layers 141, 142, 143, and 144 by gate dielectric layers 162. The gate electrode 165 may include a conductive material, and may include, for example, a metal nitride such as a titanium nitride (TiN), a tantalum nitride (TaN), or a tungsten nitride (WN), and/or a metal material such as aluminum (Al), tungsten (W), or molybdenum (Mo), or a semiconductor material such as doped polysilicon. According to some embodiments, the gate electrode 165 may be formed as two or more multilayers.

The gate spacer layers 164 may be disposed on both side surfaces of the gate electrode 165 on the channel structure 140. The gate spacer layers 164 may insulate the source/drain regions 150 and the gate electrode 165. The gate spacer layers 164 may be formed as a multilayer structure, according to some embodiments. The gate spacer layers 164 may be formed of at least one of an oxide, a nitride, or an oxynitride, and may be formed as, for example, a low-x film.

The gate capping layer 167 may extend in the second direction (Y-direction) on the gate electrode 165 and the gate spacer layers 164. The gate capping layer 167 may include at least one of an oxide, a nitride, or an oxynitride.

Each of the first gate structures 160a may include a first gate electrode 165a, first gate dielectric layers 162a between the first gate electrode 165a and first to fourth channel layers 141a, 142a, 143a, and 144a, first gate spacer layers 164a on side surfaces of the first gate electrode 165a, and a first gate capping layer 167a extending in the second direction (Y-direction) on the first gate electrode 165a.

Each of the second gate structures 160b may include a second gate electrode 165b, second gate dielectric layers 162b between the second gate electrode 165b and first to fourth channel layers 141b, 142b, 143b, and 144b, second gate spacer layers 164b on side surfaces of the second gate electrode 165b, and a second gate capping layer 167b extending in the second direction (Y-direction) on the second gate electrode 165b.

The channel structures 140 may be disposed on the active pattern 105 in regions in which the active pattern 105 intersects the gate structures 160. The channel structures 140 may include first channel structures 140a surrounded by the first gate structures 160a in the first region R1, and second channel structures 140b surrounded by the second gate structures 160b in the second region R2. As used herein, it will be understood that "an element A surrounds an element B" (or similar language) means that the element A is at least partially around the element B but does not necessarily mean that the element A completely encloses the element B. In some embodiments, a first channel length of the first channel structures 140a extending in the first direction (X-direction) may be substantially equal to a second channel length of the second channel structures 140b extending in the first direction (X-direction). For example, a first channel length of the first channel structures 140a extending in the first direction (X-direction) and a second channel length of the second channel structures 140b extending in the first direction (X-direction) may be substantially equal to the third width W2 of the first gate structures 160a and the third width W2 of the second gate structures 160b in the first direction (X-direction).

Each of the channel structures 140 may include first to fourth channel layers 141, 142, 143, and 144, which may be a plurality of channel layers disposed spaced apart from each other in a third direction (Z-direction). The first to fourth channel layers 141, 142, 143, and 144 may be disposed sequentially from the top, and the first channel layer 141 may be an uppermost channel layer. The channel structures 140 may be connected to the source/drain regions 150. The channel structures 140 may have a width, equal to or similar to a width of the gate structures 160 in the first direction (X-direction), and may have a width, equal to or smaller than a width of the active pattern 105 in the second direction (Y-direction). In the cross-section in the second direction (Y-direction) (e.g., see FIG. 3), among the first to fourth channel layers 141, 142, 143, and 144, a channel layer disposed in a lower portion may have a width, equal to or greater than a width of a channel layer disposed in an upper portion. The number and shapes of channel layers forming one channel structure 140 may be changed in embodiments. For example, one channel structure 140 may include three channel layers, may include two channel layers, or may include five or more channel layers. The channel layer disposed on a lowermost level, among the plurality of channel layers, may be referred to as a lowermost channel layer. For example, when one channel structure 140 includes four channel layers, the fourth channel layer 144 may be the lowermost channel layer. In some embodiments, different from that illustrated, when one channel structure 140 includes three channel layers, the third channel layer 143 disposed third from the top may be referred to as the lowermost channel layer.

The channel structures 140 may be formed of a semiconductor material, and may include, for example, at least one of silicon (Si), silicon germanium (SiGe), or germanium (Ge). The channel structures 140 may be formed of, for example, the same material as the active pattern 105. In some embodiments, the channel structures 140 may include an impurity region located in a region adjacent to the source/drain regions 150.

The channel structures 140 may include first channel structures 140a disposed in the first region R1, and second channel structures 140b disposed in the second region R2.

The first channel structures 140a may include first to fourth channel layers 141a, 142a, 143a, and 144a that may be a plurality of channel layers spaced apart from each other in the third direction (Z-direction). The first channel structures 140a may be connected to the first source/drain region 150a. The first channel structures 140a may have a width, equal to or similar to a width of the first gate structures 160a in the first direction (X-direction), and may have a width, equal to or smaller than a width of the first active pattern 105a in the second direction (Y-direction).

The second channel structures 140b may include first to fourth channel layers 141b, 142b, 143b, and 144b that may be a plurality of channel layers spaced apart from each other in the third direction (Z-direction). The second channel structures 140b may be connected to the second source/drain region 150b. The second channel structures 140b may have a width, equal to or similar to a width of the second gate structures 160b in the first direction (X-direction), and may have a width, equal to or smaller than a width of the second active pattern 105b in the second direction (Y-direction).

The width of each of the first channel structures 140a in the first direction (X-direction) may be equal to or similar to the width of each of the second channel structures 140b in the first direction (X-direction). In some embodiments, the width of each of the first channel structures 140a in the second direction (Y-direction) may be greater than the width of each of the second channel structures 140b in the second direction (Y-direction). For example, widths of the first to fourth channel layers 141a, 142a, 143a, and 144a in the second direction (Y-direction) may be greater than widths of the first to fourth channel layers 141b, 142b, 143b, and 144b in the second direction (Y-direction).

The source/drain regions 150 may include first source/drain regions 150a disposed in the first region R1, and second source/drain regions 150b disposed in the second region R2.

The first source/drain regions 150a may be disposed between the first gate structures 160a, and may be disposed in recessed regions partially recessing an upper portion of the first active pattern 105a. The recessed regions may extend along side surfaces of the first channel structures 140a and side surfaces of the first gate dielectric layers 162a. The first source/drain regions 150a may be disposed to be on (e.g., to cover and/or overlap) side surfaces of each of the first to fourth channel layers 141a, 142a, 143a, and 144a of the first channel structures 140a in the first direction (X-direction). Upper surfaces of the first source/drain regions 150a may be located on a level, equal to or higher than a lower surface of the first gate electrodes 165a on the first channel layer 141a, and the level may be variously changed in embodiments. Side surfaces of the first source/drain region 150a may have a curvature according to the first to fourth channel layers 141a, 142a, 143a, and 144a and the first gate structure 160a.

The second source/drain regions 150b may be disposed between the second gate structures 160b, and may be disposed in recessed regions partially recessing an upper portion of the second active pattern 105b. The recessed regions may extend along side surfaces of the second channel structures 140b and side surfaces of the second gate dielectric layers 162b. The second source/drain region 150b may be disposed to be on (e.g., to cover and/or overlap) side surfaces of each of the first to fourth channel layers 141b, 142b, 143b, and 144b of the second channel structures 140b in the first direction (X-direction). Upper surfaces of the second source/drain regions 150b may be located on a level, equal to or higher than a lower surface of the second gate electrodes 165b on the first channel layer 141b, and the level may be variously changed in embodiments. Side surfaces of the second source/drain regions 150b may have a curvature according to the first to fourth channel layers 141b, 142b, 143b, and 144b and the second gate structure 160b. Specific shapes of the side surfaces of the first and second source/drain regions 150a and 150b may be variously changed in embodiments.

When viewed in a cross-section in the second direction (Y-direction) (e.g., see FIG. 4A), the first source/drain region 150a may include a first extension portion 151a and a first expansion portion 152a extending from the first extension portion 151a. The first extension portion 151a may be in contact with an upper surface of the first active pattern 105a, and may have a width, equal to or similar to a width of the first active pattern 105a in the second direction (Y-direction). For example, the first extension portion 151a may extend in the third direction (Z-direction) on the first active pattern 105a. The first expansion portion 152a may extend from the first extension portion 151a, and may have a width increasing and then decreasing in an upward direction (e.g., in the third direction (Z-direction)). For example, the first expansion portion 152a may have a width in the second direction (Y-direction) that increases and then decreases when moving in the third direction (Z-direction) away from the substrate 101.

When viewed in a cross-section in the second direction (Y-direction) (e.g., see FIG. 4A), the second source/drain region 150b may include a second extension portion 151b and a second expansion portion 152b extending from the second extension portion 151b. The second extension portion 151b may be in contact with an upper surface of the second active pattern 105b, and may have a width, equal to or similar to a width of the second active pattern 105b in the second direction (Y-direction). For example, the second extension portion 151b may extend in the third direction (Z-direction) on the second active pattern 105b. The second expansion portion 152b may extend from the second extension portion 151b, and may have a width increasing and then decreasing in an upward direction. For example, the second expansion portion 152b may have a width in the second direction (Y-direction) that increases and then decreases when moving in the third direction (Z-direction) away from the substrate 101.

The width of the first extension portion 151a of the first source/drain region 150a in the second direction (Y-direction) may be greater than the width of the second extension portion 151b of the second source/drain region 150b in the second direction (Y-direction). In some embodiments, a first height H1 of the first extension portion 151a of the first source/drain region 150a in the third direction (Z-direction) may be smaller than a second height H2 of the second extension portion 151b of the second source/drain region 150b in the third direction (Z-direction).

An upper surface of the first source/drain region 150a may be disposed on substantially the same level as (i.e., may be substantially coplanar with) an upper surface of the second source/drain region 150b. An upper surface of the first expansion portion 152a of the first source/drain region 150a may be disposed on substantially the same level as an upper surface of the second expansion portion 152b of the second source/drain region 150b. In some embodiments, each of the first expansion portion 152a and the second expansion portion 152b may have a slope turning point at which a width increases and then decreases in an upward direction. The slope turning point of the first expansion portion 152a may be disposed on a level, lower than a level of the slope turning point of the second expansion portion 152b. In other words, a width of the first expansion portion 152a may transition from increasing to decreasing at a first point in the third direction (Z-direction) when moving away from the substrate 101, and a width of the second expansion portion 152b may transition from increasing to decreasing at a second point in the third direction (Z-direction) when moving away from the substrate 101. In some embodiments, the first point may be lower than the second point in the third direction (Z-direction), relative to the substrate 101 (e.g., relative to an upper surface of the substrate 101).

Cross-sectional shapes of the first extension portion 151a of the first source/drain region 150a and the second extension portion 151b of the second source/drain region 150b in the second direction (Y-direction) may have a rectangular shape, and cross-sectional shapes of the first expansion portion 152a of the first source/drain region 150a and the second expansion portion 152b of the second source/drain region 150b in the second direction (Y-direction) may have a hexagonal shape. In some embodiments, a cross-sectional area of the first expansion portion 152a of the first source/drain region 150a in the second direction (Y-direction) may be greater than a cross-sectional area of the second expansion portion 152b of the second source/drain region 150b in the second direction (Y-direction). In other words, a cross-sectional area of the first expansion portion 152a may be greater than a cross-sectional area of the second expansion portion 152b, when viewed along the second direction (Y-direction) (e.g., see FIG. 4A).

The source/drain regions 150 may include a semiconductor material, for example, at least one of silicon (Si) or germanium (Ge). The source/drain regions 150 may include epitaxial layers formed as a plurality of layers, and the plurality of epitaxial layers may have different compositions. For example, concentrations of non-silicon elements of the plurality of epitaxial layers may be different from each other. The non-silicon elements may be, for example, germanium (Ge) and/or doping elements.

The source/drain regions 150 may further include impurities. For example, when the semiconductor device 100 is a pFET, the impurities may be at least one of boron (B), gallium (Ga), or indium (In), and when the semiconductor device 100 is an nFET, the impurities may be at least one of phosphorus (P), arsenic (As), or antimony (Sb). According to example embodiments, the source/drain region 150 may include a plurality of regions including elements and/or doping elements of different concentrations.

The first fin spacers 155a may be disposed on a side surface of the first source/drain region 150a, may surround the first extension portion 151a, and may expose the first expansion portion 152a. For example, the first fin spacers 155a may be on side surfaces of the first extension portion 151a, and side surfaces of the first expansion portion 152a may be free of the first fin spacers 155a thereon. In other words, the first extension portion 151a may have opposite side surfaces in the second direction (Y-direction), with the first fin spacers 155a thereon, and the first expansion portion 152a may have opposite side surfaces in the second direction (Y-direction) that are free of the first fin spacers 155a thereon. The first fin spacers 155a may be disposed to be spaced apart from each other in the second direction (Y-direction), but may surround the first extension portion 151a exposed in the second direction (Y-direction). For example, the first fin spacers 155a may extend from an outer side surface of the first extension portion 151a of the first source/drain region 150a to an upper surface of the device isolation layer 110. In other words, the first fin spacers 155a may extend from side surfaces of the first extension portion 151a onto the device isolation layer 110. As shown in FIGS. 1 and 4A, the first fin spacers 155a may be on the device isolation layer 110 between the first gate structures 160a (e.g., in the first direction (X-direction)). For example, the first fin spacers 155a may define a region in which the first extension portion 151a of the first source/drain region 150a is formed. A gap between the first fin spacers 155a in the second direction (Y-direction) may be substantially equal to the first width W1a of the first active pattern 105a in the second direction (Y-direction).

The second fin spacers 155b may be disposed on a side surface of the second source/drain region 150b, may surround the second extension portion 151b, and may expose the second expansion portion 152b. For example, the second fin spacers 155b may be on side surfaces of the second extension portion 151b, and side surfaces of the second expansion portion 152b may be free of the second fin spacers 155b thereon. In other words, the second extension portion 151b may have opposite side surfaces in the second direction (Y-direction), with the second fin spacers 155b thereon, and the second expansion portion 152b may have opposite side surfaces in the second direction (Y-direction) that are free of the second fin spacers 155b thereon. The second fin spacers 155b may be disposed to be spaced apart in the second direction (Y-direction), and may surround the second extension portion 151b exposed in the second direction (Y-direction). The second fin spacers 155b may extend from an outer side surface of the second extension portion 151b of the second source/drain region 150b to an upper surface of the device isolation layer 110. In other words, the second fin spacers 155b may extend from side surfaces of the second extension portion 151b onto the device isolation layer 110. As shown in FIGS. 1 and 4A, the second fin spacers 155b may be on the device isolation layer 110 between the second gate structures 160b (e.g., in the first direction (X-direction)). The second fin spacers 155b may define a region in which the second extension portion 151b of the second source/drain region 150b is formed. A gap between the second fin spacers 155b in the second direction (Y-direction) may be substantially equal to the second width W1b of the second active pattern 105b in the second direction (Y-direction). In some embodiments, the gap of the second fin spacers 155b in the second direction (Y-direction) may be smaller than the gap of the first fin spacers 155a in the second direction (Y-direction). In other words, a distance between the first fin spacers 155a in the second direction (Y-direction) may be greater than a distance between the second fin spacers 155b in the second direction (Y-direction). For example, the first fin spacers 155a may be on opposite sides of the first source/drain region 150a (e.g., in the second direction (Y-direction)), and the second fin spacers 155b may be on opposite sides of the second source/drain region 150b (e.g., in the second direction (Y-direction)).

A height of each of the first fin spacers 155a may correspond to a height (e.g., the first height H1) of the first extension portion 151a of the first source/drain region 150a, and a height of each of the second fin spacers 155b may correspond to a height (e.g., the second height H2) of the second extension portion 151b of the second source/drain region 150b. In some embodiments, the height of each of the first fin spacers 155a may be smaller than the height of each of the second fin spacers 155b. The height of each of the first fin spacers 155a may be a length in the third direction (Z-direction) from a lower surface to an upper surface of each of the first fin spacers 155a. The height of each of the second fin spacers 155b may be a length in the third direction (Z-direction) from a lower surface to an upper surface of each of the second fin spacers 155b. Since the lower surface of the first fin spacer 155a may be disposed on substantially the same level as the lower surface of the second fin spacer 155b, the upper surface of the first fin spacer 155a may be disposed on a level, lower than a level of the upper surface of the second fin spacer 155b.

Since the second fin spacers 155b, higher than the first fin spacers 155a disposed on a side surface of the first source/drain region 150a, may be disposed on a side surface of the second source/drain region 150b, to keep capacitance of a field-effect transistor of the second region R2 low, reliability and electrical characteristics of a low-power element disposed in the second region R2 may be ensured.

An area of an outer side surface of the first expansion portion 152a of the first source/drain region 150a exposed by the first fin spacer 155a may be larger than (i.e., greater than) an area of an outer side surface of the second expansion portion 152b of the second source/drain region 150b exposed by the second fin spacer 155b.

The first fin spacers 155a and the second fin spacers 155b may include the same material as the gate spacer layers 164. In some embodiments, the first fin spacers 155a and the second fin spacers 155b may include an oxide, a nitride, or a combination thereof. In some embodiments, the first fin spacers 155a and the second fin spacers 155b may be formed as a low-κ film, and may include, for example, at least one of SiO, SiN, SiCN, SiOC, SiON, SiOCN, or a combination thereof.

The interlayer insulating layer 170 may be located on the device isolation layer 110 to be on (e.g., to cover and/or overlap) the source/drain regions 150 and the contact plug 180. For example, the interlayer insulating layer 170 may be on the first fin spacers 155a, the second fin spacers 155b, the first expansion portion 152a, the second expansion portion 152b, and the device isolation layer 110. The interlayer insulating layer 170 may include at least one of an oxide, a nitride, or an oxynitride, and may include, for example, a low-κ material. According to some embodiments, the interlayer insulating layer 170 may include a plurality of insulating layers.

The contact plugs 180 may penetrate (i.e., extend into) the interlayer insulating layer 170, may be connected to the source/drain regions 150, and may apply an electrical signal to the source/drain regions 150. The contact plugs 180 may recess the source/drain regions 150, and may extend into the source/drain regions 150. For example, the contact plugs 180 may extend into upper surfaces of the source/drain regions 150. The contact plugs 180 may extend from the top, for example, below an upper surface of the first channel layer 141. In some embodiments, the contact plugs 180 may extend below a lower surface of the first channel layer 141.

The contact plugs 180 may include a first contact plug 180a penetrating the interlayer insulating layer 170 and connected to the first source/drain region 150a, and a second contact plug 180b connected to the second source/drain region 150b. For example, the first contact plug 180a may recess the first source/drain region 150a, and may extend into the first source/drain region 150a. The second contact plug 180b may recess the second source/drain region 150b, and may extend into the second source/drain region 150b. In some embodiments, a length of a lower surface of the first contact plug 180a in the second direction (Y-direction) may be greater than a length of a lower surface of the second contact plug 180b in the second direction (Y-direction).

A semiconductor device according to example embodiments may include a first region R1 in which a high-power field-effect transistor is disposed, and a second region R2 in which a low-power field-effect transistor is disposed. In the first region R1, a first active pattern 105a having a first width W1a, and a first source/drain region 150a having a first extension portion 151a connected to the first active pattern 105a and surrounded by a first fin spacer 155a, may be disposed, and in the second region R2, a second active pattern 105b having a second width W1b, smaller than the first width W1a, and a second source/drain region 150b having a second extension portion 151b connected to the second active pattern 105b and surrounded by a second fin spacer 155b and having a higher height than the first extension portion 151a, may be disposed. Therefore, a relatively low capacitance of a low-power field-effect transistor may be secured, and thus a semiconductor device having improved reliability and electrical characteristics may be provided.

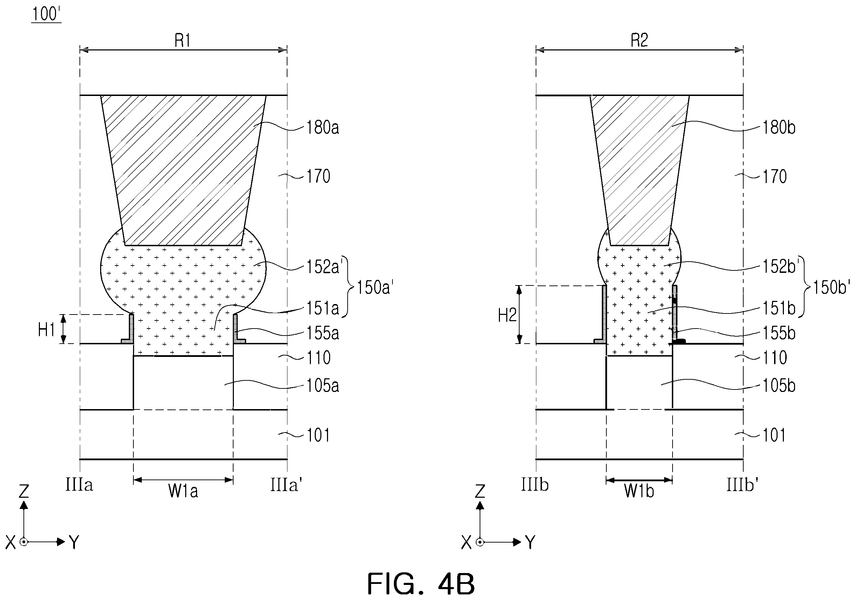

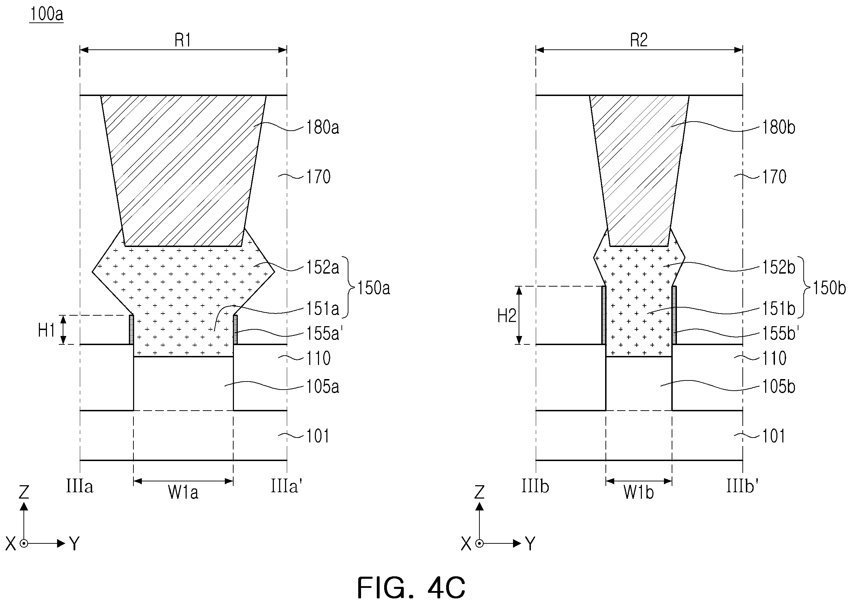

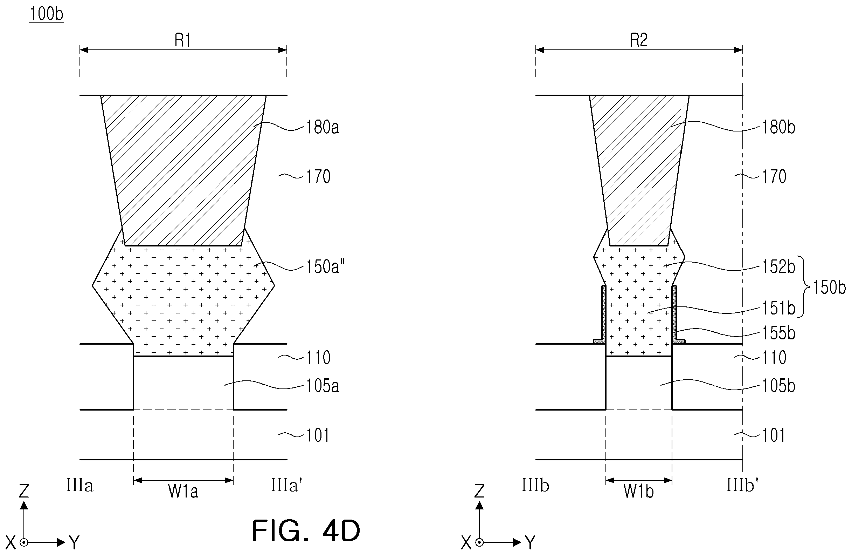

FIGS. 4B, 4C, and 4D are cross-sectional views taken along lines IIIa-IIIa' and IIIb-IIIb' of FIG. 1 according to further embodiments.

Referring to FIG. 4B, a semiconductor device 100' may include a first source/drain region 150a' and a second source/drain region 150b'. Remaining configurations of the semiconductor device 100', except for the first source/drain regions 150a' and the second source/drain regions 150b' illustrated in FIG. 4B, may be identical to or correspond to the configurations illustrated in FIG. 4A. Duplicate descriptions of identical or corresponding configurations may thus be omitted.

The first source/drain region 150a' may include a first extension portion 151a disposed on a first active pattern 105a, and a first expansion portion 152a' extending from the first extension portion 151a. The second source/drain region 150b' may include a second extension portion 151b disposed on a second active pattern 105b, and a second expansion portion 152b' extending from the second extension portion 151b.

Cross-sectional shapes of the first extension portion 151a of the first source/drain region 150a' and the second extension portion 151b of the second source/drain region 150b' in the second direction (Y-direction) may have a rectangular shape. The first expansion portion 152a' of the first source/drain region 150a' and the second expansion portion 152b' of the second source/drain region 150b' may have a curve in which a width increases and then decreases in the second direction (Y-direction). For example, side surfaces of the first expansion portion 152a' of the first source/drain region 150a' and the second expansion portion 152b' of the second source/drain region 150b' may have a curved shape (e.g., a rounded shape). In some embodiments, the first expansion portion 152a' of the first source/drain region 150a' and the second expansion portion 152b' of the second source/drain region 150b' may have a width in the second direction (Y-direction) that increases and then decreases when moving in the third direction (Z-direction) away from the substrate 101. A cross-sectional area of the first expansion portion 152a' of the first source/drain region 150a' in the second direction (Y-direction) may be larger than a cross-sectional area of the second expansion portion 152b' of the second source/drain region 150b' in the second direction (Y-direction).

Referring to FIG. 4C, a semiconductor device 100a may include first fin spacers 155a' disposed on a side surface of a first source/drain region 150a and second fin spacers 155b' disposed on a side surface of a second source/drain region 150b. Remaining configurations of the semiconductor device 100a, except for the first fin spacers 155a' and the second fin spacers 155b' illustrated in FIG. 4C, may be identical to or correspond to those illustrated in FIG. 4A. Duplicate descriptions of identical or corresponding configurations may thus be omitted. The first fin spacers 155a' may surround a first extension portion 151a of the first source/drain region 150a, and may not extend to an upper surface of a device isolation layer 110, and the second fin spacers 155b' may surround a second extension portion 151b of the second source/drain region 150b, and may not extend to the upper surface of the device isolation layer 110. For example, each of the first fin spacers 155a' and each of the second fin spacers 155b' may be spaced apart from each other in the second direction (Y-direction), and may be disposed in a plate type.

Referring to FIG. 4D, a semiconductor device 100b may include a first source/drain region 150a" and a second source/drain region 150b. Remaining configurations of the semiconductor device 100b, except for the first source/drain region 150a" illustrated in FIG. 4D, may be identical to or correspond to those illustrated in FIG. 4A. Duplicate descriptions of identical or corresponding configurations may thus be omitted. The first source/drain region 150a" may be in contact with an upper surface of a first active pattern 105a, and may have a width increasing and then decreasing in an upward direction. For example, the first source/drain region 150a" may have a width in the second direction (Y-direction) that increases and then decreases when moving in the third direction (Z-direction) away from the substrate 101. Since no spacer may be disposed on a side surface of the first source/drain region 150a", the side surface of the first source/drain region 150a" may be exposed from a device isolation layer 110, and may be in contact with an interlayer insulating layer 170. The second source/drain region 150b may include a second extension portion 151b covered by second fin spacers 155b, and a second expansion portion 152b extending from the second extension portion 151b, exposed from the second fin spacers 155b, and having a width increasing and then decreasing in an upward direction.

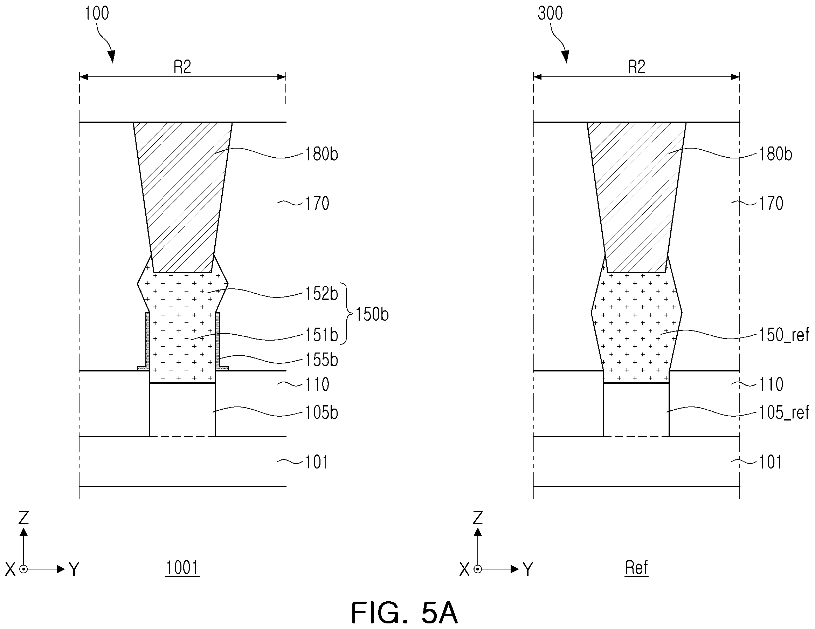

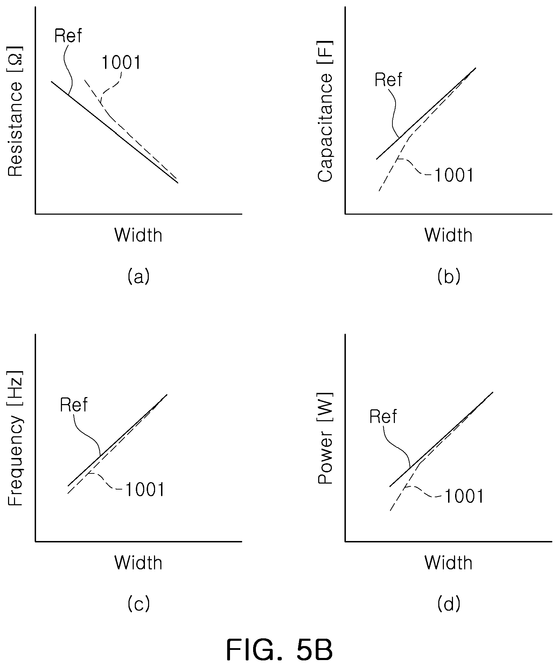

FIGS. 5A and 5B are views illustrating electrical characteristics according to a width of an active pattern of a semiconductor device 100 and a width of an active pattern of a reference semiconductor device 300.

Referring to FIGS. 5A and 5B, a first transistor 1001 may be a low-power field-effect transistor disposed in a second region R2 of a semiconductor device 100 according to some embodiments, and a reference transistor Ref may be a low-power field-effect transistor disposed in a second region R2 of a reference semiconductor device 300. The reference semiconductor device 300 may have a reference active pattern 105_ref having the same width in the second direction (Y-direction) as a second active pattern 105b of the semiconductor device 100 according to some embodiments, and may have a reference source/drain region 150_ref not surrounded by a fin spacer. For example, a cross-sectional area of a second source/drain region 150b of the semiconductor device 100 in the second direction (Y-direction) may be smaller than a cross-sectional area of the reference source/drain region 150_ref of the reference semiconductor device 300 in the second direction (Y-direction).

Referring to FIG. 5B, a graph (a) represents resistance according to a width of an active pattern, a graph (b) represents capacitance according to a width of an active pattern, a graph (c) represents frequency according to a width of an active pattern, and a graph (d) represents power according to a width of an active pattern.

Referring to graph (a) of FIG. 5B, a resistance of the first transistor 1001 may increase, as a width of the second active pattern 105b decreases, as compared to the reference transistor Ref. Referring to graph (b) of FIG. 5B, a capacitance of the first transistor 1001 may decrease, as the width of the second active pattern 105b decreases, as compared to the reference transistor Ref. Referring to graph (c) of FIG. 5B, the first transistor 1001 may have a similar frequency value as the reference transistor Ref, depending on the width of the second active pattern 105b. Referring to graph (d) of FIG. 5B, the first transistor 1001 may have a lower power value, as the width of the second active pattern 105b decreases, as compared to the reference transistor Ref.

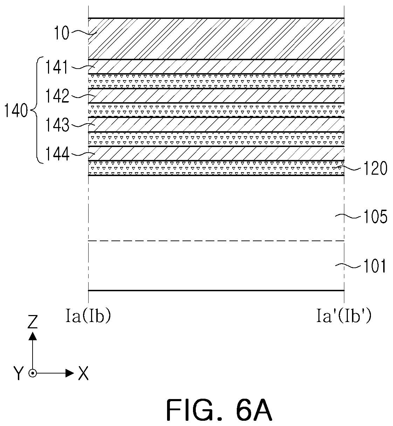

FIGS. 6A, 6B, 7, 8A, 8B, 9A, 9B, 9C, 10A, 10B, 11, and 12 are views illustrating a process sequence for a method of manufacturing a semiconductor device according to embodiments. In particular, FIGS. 6A, 8A, 9A, 10A, 11, and 12 illustrate cross-sectional views corresponding to FIG. 2, and FIGS. 6B, 7, 8B, 9B, 9C, and 10B illustrate cross-sectional views corresponding to FIG. 4A.

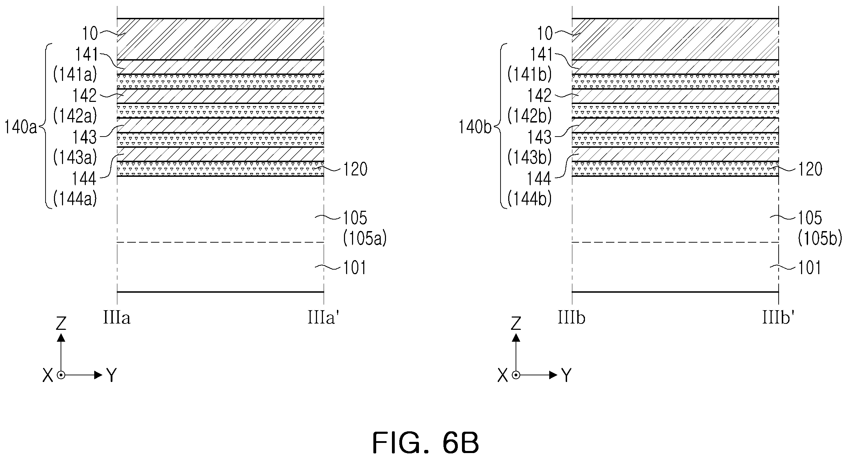

Referring to FIGS. 6A and 6B, first to fourth channel layers 141, 142, 143, and 144 and sacrificial layers 120 may be alternately stacked on a substrate 101, and active structures including active patterns 105 may be formed.

The sacrificial layers 120 may be layers that may be replaced with gate dielectric layers 162 and gate electrodes 165 below the first channel layer 141 by a subsequent process, as illustrated in FIGS. 2 and 3. The sacrificial layers 120 may be formed of a material having etch selectivity with respect to the first to fourth channel layers 141, 142, 143, and 144, respectively. The first to fourth channel layers 141, 142, 143, and 144 may include a material different from the sacrificial layers 120. The sacrificial layers 120 and the first to fourth channel layers 141, 142, 143, and 144 may include a semiconductor material including at least one of, for example, silicon (Si), silicon germanium (SiGe), or germanium (Ge), but may include different materials, and may or may not include impurities. For example, the sacrificial layers 120 may include silicon germanium (SiGe), and the first to fourth channel layers 141, 142, 143, and 144 may include silicon (Si).

The sacrificial layers 120 and the first to fourth channel layers 141, 142, 143, and 144 may be formed by performing an epitaxial growth process from the stacked structure. The number of layers of the channel layers alternately stacked with the sacrificial layers 120 may be changed in embodiments.

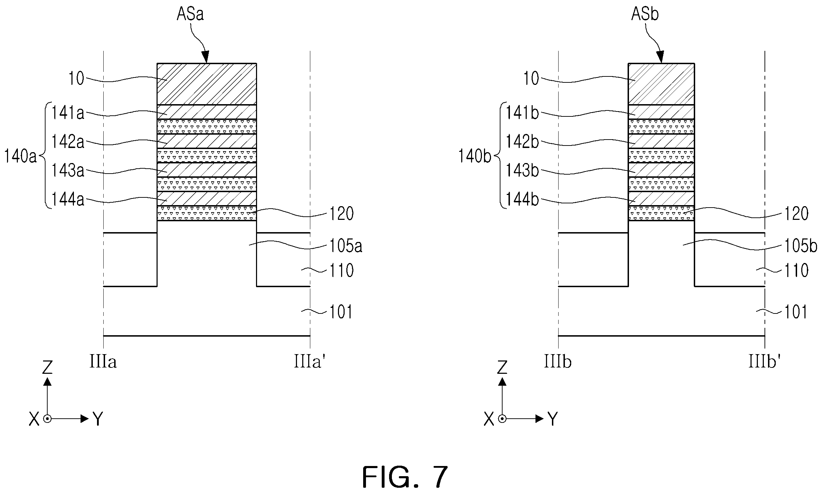

Referring to FIG. 7, the sacrificial layers 120, the first to fourth channel layers 141, 142, 143, and 144, and the active patterns 105 may be partially removed to form a first active structure ASa including a first active pattern 105a and a second active structure ASb including a second active pattern 105b.

The first active structure ASa may include the first active pattern 105a, the sacrificial layers 120, and first to fourth channel layers 141a, 142a, 143a, and 144a, and the first active structure ASa may be formed in a linear shape extending in the first direction (X-direction), for example. The second active structure ASb may include the second active pattern 105b, the sacrificial layers 120, and first to fourth channel layers 141b, 142b, 143b, and 144b. The second active structure ASb may be formed, for example, in a linear shape extending in the first direction (X-direction). The first active pattern 105a and the second active pattern 105b may be disposed side by side in the first direction (X-direction), but may have different widths in the second direction (Y-direction). The first active pattern 105a may have a first width in the second direction (Y-direction), and the second active pattern 105b may have a second width, smaller than the first width, in the second direction (Y-direction). An etching mask 10 may be disposed on an upper surface of the first channel layer 141, and may be formed as a plurality of layers, and may include, for example, a first etching mask layer formed of polysilicon, and a second etching mask layer formed of a nitride on the first etching mask layer.

In a region from which a portion of each of the first and second active patterns 105a and 105b, the sacrificial layers 120, and the first to fourth channel layers 141, 142, 143, and 144 are removed, an insulating material may be buried and then a portion of the insulating material may be removed, such that the first and second active patterns 105a and 105b may protrude to form a device isolation layer 110. An upper surface of the device isolation layer 110 may be formed to be lower than upper surfaces of the first and second active patterns 105a and 105b.

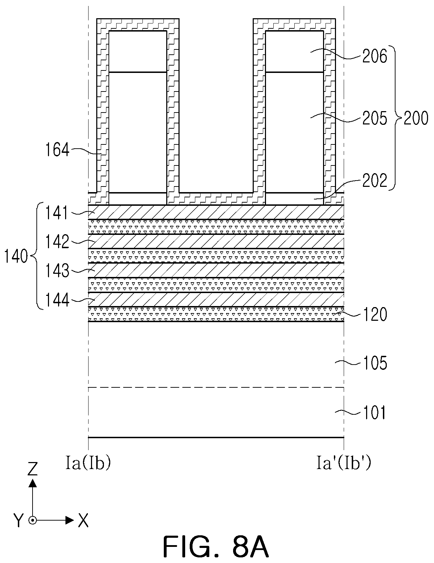

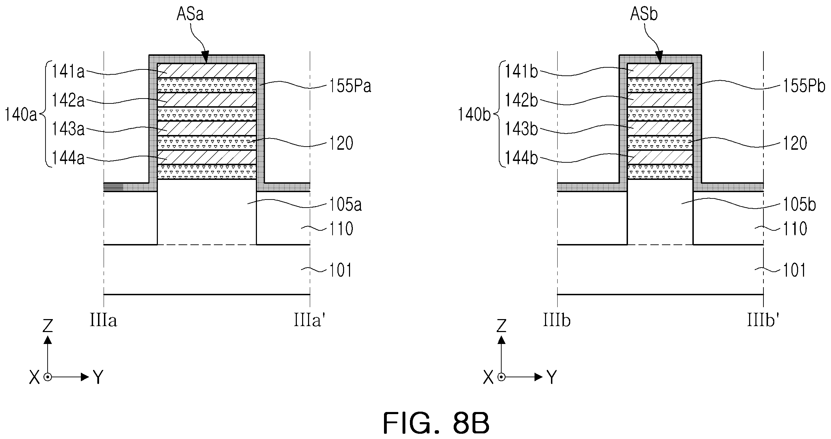

Referring to FIGS. 8A and 8B, sacrificial gate structures 200 on the first and second active structures ASa and ASb, gate spacer layers 164 on (e.g., covering and/or overlapping) the sacrificial gate structures 200, and first and second preliminary spacers 155Pa and 155Pb on (e.g., covering and/or overlapping) the first and second active structures ASa and ASb may be formed.

The sacrificial gate structure 200 may be a sacrificial structure formed in a region in which a gate dielectric layer 162 and a gate electrode 165 are disposed on channel structures 140 by a subsequent process, as illustrated in FIGS. 2 and 3. As illustrated in FIGS. 2, 8A, and 8B, the sacrificial gate structure 200 may not be formed in a region in which the first and second source/drain regions 150a and 150b are to be formed. The sacrificial gate structure 200 may be in a linear shape extending in the second direction (Y-direction) intersecting the first and second active structures ASa and ASb. The sacrificial gate structures 200 may, for example, extend in the second direction (Y-direction), and may be disposed spaced apart from each other in the first direction (X-direction).

The sacrificial gate structure 200 may include first and second sacrificial gate layers 202 and 205 and a mask pattern layer 206, sequentially stacked. The first and second sacrificial gate layers 202 and 205 may be patterned using the mask pattern layer 206. The first and second sacrificial gate layers 202 and 205 may be an insulating layer and a conductive layer, respectively, but are not limited thereto, and the first and second sacrificial gate layers 202 and 205 may be formed as a single layer. For example, the first sacrificial gate layer 202 may include silicon oxide, and the second sacrificial gate layer 205 may include polysilicon. The mask pattern layer 206 may include silicon oxide and/or silicon nitride.

The gate spacer layer 164 may be formed to conformally extend on (e.g., to conformally cover) the upper surface of the first channel layer 141, and upper and side surfaces of the sacrificial gate structure 200. The first preliminary spacer 155Pa may be formed to conformally extend on (e.g., to conformally cover) the first active structure ASa, and the second preliminary spacer 155Pb may be formed to conformally extend on (e.g., to conformally cover) the second active structure ASb. The gate spacer layer 164, the first preliminary spacer 155Pa, and the second preliminary spacer 155Pb may be formed by the same process. For example, when an insulating material is deposited for forming a gate spacer layer 164, the insulating material may be formed to be on (e.g., to cover and/or overlap) each of the first and second active structures ASa and ASb, to form the first and second preliminary spacers 155Pa and 155Pb.

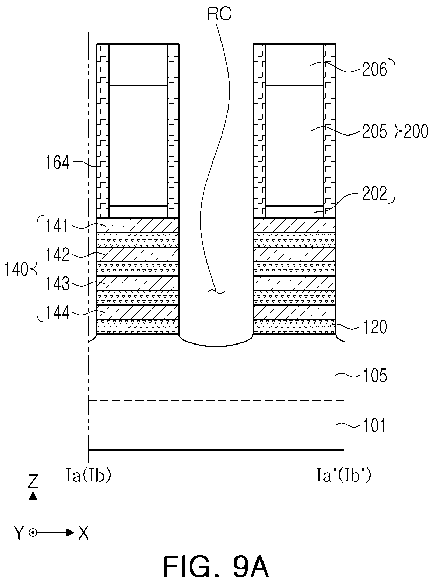

Referring to FIG. 9A, the sacrificial layers 120 and the first to fourth channel layers 141, 142, 143, and 144, exposed from the sacrificial gate structures 200, may be partially removed to form recessed regions RC.

Using the sacrificial gate structures 200 and the gate spacer layers 164 as masks, the recessed regions RC may be formed by removing a portion of the exposed sacrificial layers 120 and a portion of the first to fourth channel layers 141, 142, 143, and 144. As a result, the first to fourth channel layers 141, 142, 143, and 144 may form channel structures 140 having a limited length in the first direction (X-direction). In some embodiments, different from that illustrated, side surfaces of the sacrificial layers 120 may be selectively etched with respect to the channel structures 140 by a wet etching process, and may be removed from the side surfaces in the first direction (X-direction) to a predetermined depth. Therefore, the sacrificial layers 120 may have concave side surfaces inwardly by lateral etching, as described above. Specific shapes of the side surfaces of the sacrificial layers 120 are not limited to those illustrated in FIG. 9A.

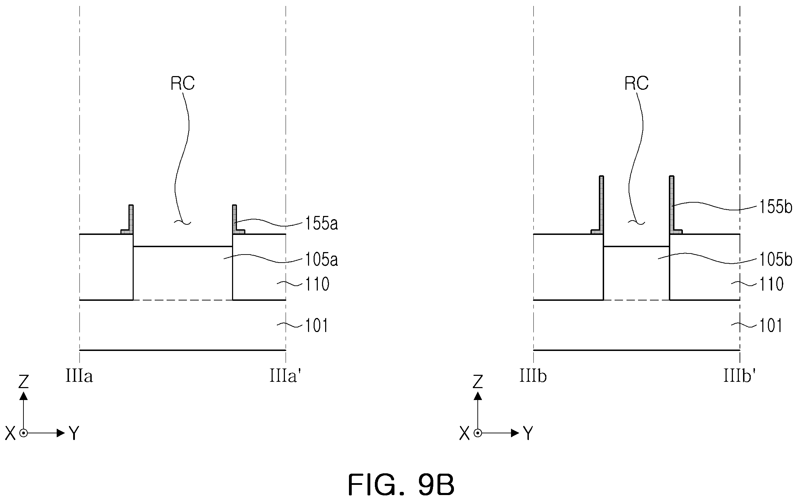

FIG. 9B is a cross-sectional view illustrating a method for manufacturing the first and second fin spacers 155a and 155b of FIG. 4A according to embodiments.

Referring to FIG. 9B, a portion of the first active structure ASa and a portion of the first preliminary spacer 155Pa (see FIG. 8B) may be removed to form a recessed region RC, and a portion of the second active structure ASb and a portion of the second preliminary spacer 155Pb (see FIG. 8B) may be removed to form a recessed region RC. For example, the first preliminary spacer 155Pa on (e.g., covering and/or overlapping) the first active structure ASa may be partially removed, due to an etching process of the first active structure ASa, to form a first fin spacer 155a, and the second preliminary spacer 155Pb on (e.g., covering and/or overlapping) the second active structure ASb may be partially removed, due to the etching process of the second active structure ASb, to form a second fin spacer 155b. A height of the first fin spacer 155a may be lower than a height of the second fin spacer 155b. For example, a height from which the first preliminary spacer 155Pa is removed may be greater than a height (or amount) from which the second preliminary spacer 155Pb is removed.

A height difference between the first fin spacer 155a and the second fin spacer 155b may be due to an etch loading effect. For example, since a width of the first active structure ASa in the second direction (Y-direction) may be greater than a width of the second active structure ASb in the second direction (Y-direction), an etching speed for the first preliminary spacer 155Pa may be faster than an etching speed for the second preliminary spacer 155Pb. Therefore, a height of the first fin spacer 155a may be lower than a height of the second fin spacer 155b.

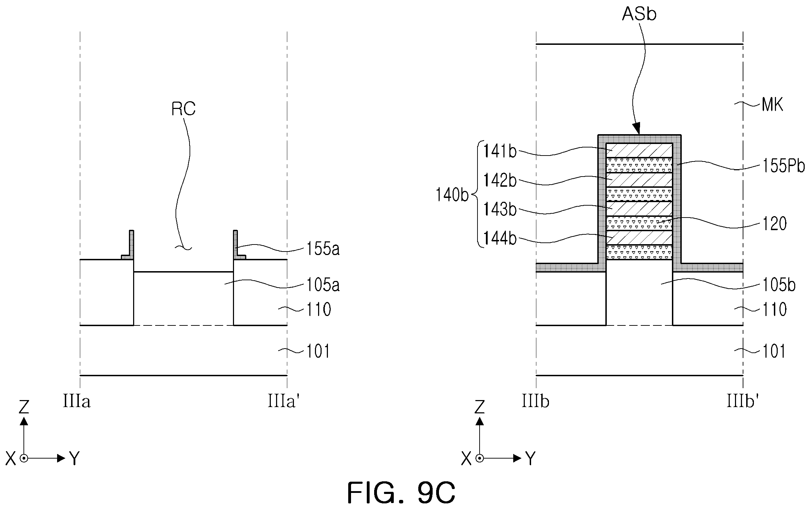

FIG. 9C is a cross-sectional view illustrating a method for manufacturing the first and second fin spacers 155a and 155b of FIG. 4A according to further embodiments.

Referring to FIG. 9C, in a state in which a mask MK on (e.g., covering and/or overlapping) the second active structure ASb is formed, the first active structure ASa and the first preliminary spacer 155Pa on (e.g., covering and/or overlapping) the first active structure ASa (see FIG. 8B) may be partially removed to form a recess region RC and a first fin spacer 155a. Although not illustrated, after the first fin spacer 155a is formed, in a state in which the mask MK on (e.g., covering and/or overlapping) the first fin spacer 155a is formed, the second active structure ASb and the second preliminary spacer 155Pb on (e.g., covering and/or overlapping) the second active structure ASb may be partially removed to form a recess region RC and a second fin spacer 155b of FIG. 9B.

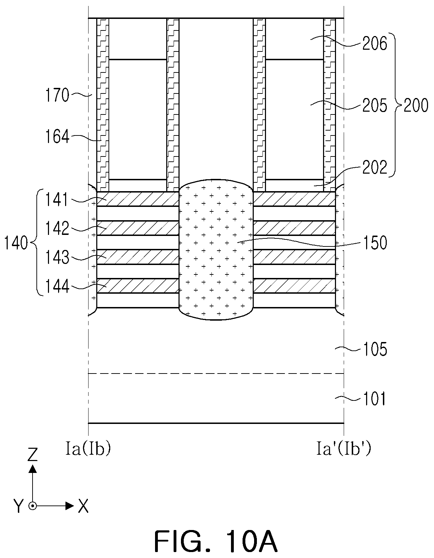

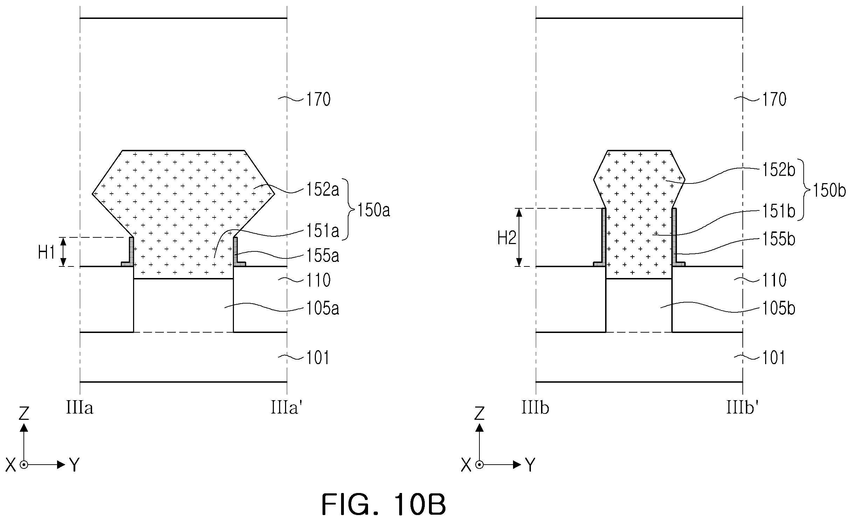

Referring to FIGS. 10A and 10B, source/drain regions 150, and an interlayer insulating layer 170 on (e.g., covering and/or overlapping) the sacrificial gate structures 200 and the source/drain regions 150 may be formed in the recess regions RC of FIGS. 9A and 9B.

A first source/drain region 150a may be formed by growing between first fin spacers 155a on an upper surface of the first active pattern 105a, and from side surfaces of the first channel structure 140a (see FIG. 2) by a selective epitaxial process. A second source/drain region 150b may be formed by growing between second fin spacers 155b on an upper surface of the second active pattern 105b, and from side surfaces of the second channel structure 140b (see FIG. 2) by a selective epitaxial process. The first source/drain region 150a may be formed to include a first extension portion 151a disposed on an upper surface of the first active pattern 105a and between the first fin spacers 155a on the device isolation layer 110, and a first expansion portion 152a extending from the first extension portion 151a and having a width increasing and then decreasing in an upward direction. The second source/drain region 150b may be formed to include a second extension portion 151b disposed on an upper surface of the second active pattern 105b and between the second fin spacers 155b on the device isolation layer 110, and a second expansion portion 152b extending from the second extension portion 151b and having a width increasing and then decreasing in an upward direction. In some embodiments, the source/drain regions 150 may include a plurality of epitaxial layers. The epitaxial layers included in the source/drain regions 150 may include impurities by in-situ doping, and may have different compositions and/or doping concentrations.

The interlayer insulating layer 170 may be formed by forming an insulating film on (e.g., covering and/or overlapping) the sacrificial gate structures 200 and the source/drain regions 150 and performing a planarization process.

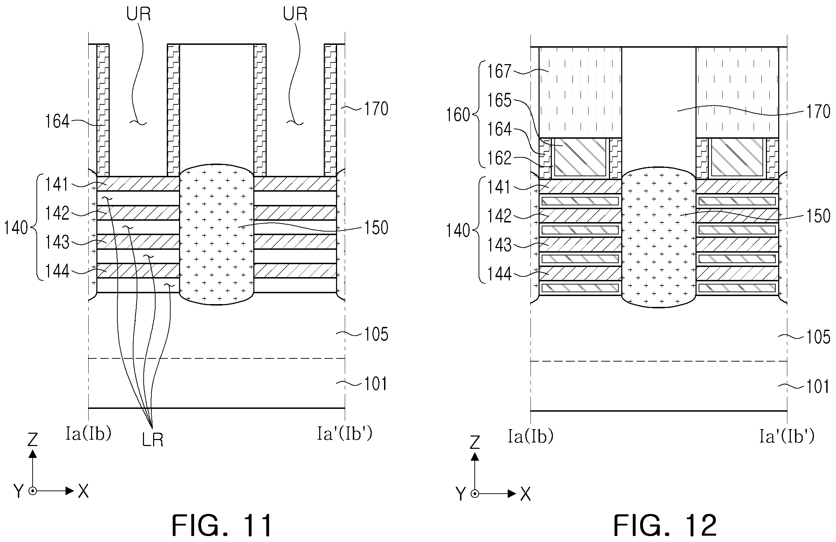

Referring to FIG. 11, the sacrificial gate structures 200 and the sacrificial layers 120 may be removed.

The sacrificial gate structures 200 and the sacrificial layers 120 may be selectively removed with respect to the gate spacer layers 164, the interlayer insulating layer 170, and the channel structures 140. First, the sacrificial gate structures 200 may be removed to form upper gap regions UR, and then the sacrificial layers 120 exposed through the upper gap regions UR may be removed to form lower gap regions LR. For example, when the sacrificial layers 120 include silicon germanium (SiGe) and the channel structures 140 include silicon (Si), the sacrificial layers 120 may be selectively removed with respect to the channel structures 140 and the source/drain regions 150 by performing a wet etching process.

Referring to FIG. 12, gate structures 160 may be formed by forming gate dielectric layers 162, gate electrodes 165, and gate capping layers 167.

The gate dielectric layers 162 and the gate electrode 165 may be formed to be in (e.g., to fill) the upper gap regions UR and the lower gap regions LR. The gate dielectric layers 162 may be formed to conformally extend on (e.g., to conformally cover) inner surfaces of the upper gap regions UR and inner surfaces of the lower gap regions LR. The gate electrode 165 may be formed to completely be in (e.g., to completely fill) the upper gap regions UR and the lower gap regions LR, and may then be removed from the upper gap regions UR to a predetermined depth, together with the gate dielectric layers 162 and the gate spacer layers 164. The gate capping layer 167 may be formed to extend in the second direction (Y-direction) on the gate electrode 165 and the gate spacer layers 164.

Referring back to FIGS. 2 and 4A, an interlayer insulating layer 170 may be penetrated to partially remove the source/drain regions 150 from the top to form a contact hole, and then the contact hole may be filled with a conductive material to form contact plugs 180. For example, the contact plugs 180 may extend into upper surfaces of the source/drain regions 150. Therefore, the semiconductor device 100 of FIGS. 1, 2, 3, and 4A may be manufactured. Although not specifically illustrated, metal interconnections electrically connected to the contact plugs 180 may be formed on the contact plugs 180.

A semiconductor device according to example embodiments may include a first source/drain region on a first active pattern having a first width and a second source/drain region on a second active pattern having a second width, smaller than the first width, and may further include first fin spacers having a first height on an outer side wall of the first source/drain region and second fin spacers having a second height, greater than the first height, on an outer side wall of the second source/drain region. Therefore, a semiconductor device having improved reliability and electrical characteristics may be provided.

Effects of the present inventive concepts are not limited to the effects described above, and may be variously expanded without departing from the scope of the present inventive concepts.

As used herein, the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof. In addition, it will be understood that, although the terms "first", "second", "third", etc. may be used herein to describe various elements, these elements should not be limited by these terms. Rather, these terms are only used to distinguish one element from another. For example, a first element could be termed a second element, and, similarly, a second element could be termed a first element, without departing from the scope of the present disclosure. Further, as used herein, the term "and/or" includes any and all combinations of one or more of the associated listed items.

While example embodiments have been illustrated and described above, it will be apparent to those skilled in the art that modifications and variations could be made without departing from the scope of the present inventive concepts as defined by the appended claims.

## Claims

1. A semiconductor device comprising:
a substrate (101) that includes a first active pattern (105a) extending in a first direction (X) and having a first width (W1a) in a second direction (Y) intersecting the first direction (X), and a second active pattern (105b) extending in the first direction (X) and having a second width (W1b) in the second direction (Y) that is less than the first width (W1a);
first gate structures (160a) spaced apart from each other in the first direction (X) and extending in the second direction (Y) on the first active pattern (105a);
second gate structures (160b) spaced apart from each other in the first direction (X) and extending in the second direction (Y) on the second active pattern (105b);
a first source/drain region (150a; 150a') on the first active pattern (105a) between the first gate structures (160a);
a second source/drain region (150b; 150b') on the second active pattern (105b) between the second gate structures (160b);
a first fin spacer (155a; 155a') on a side surface of the first source/drain region (150a; 150a'); and
a second fin spacer (155b; 155b') on a side surface of the second source/drain region (150b; 150b'),
wherein a height (H1) of the first fin spacer (155a; 155a') in a third direction (Z) intersecting the first and second directions (X, Y) is less than a height (H2) of the second fin spacer (155b; 155b') in the third direction (Z).

2. The semiconductor device of claim 1, wherein a width (W2) of each of the first gate structures (160a) in the first direction (X) is equal to a width (W2) of each of the second gate structures (160b) in the first direction (X).

3. The semiconductor device of claim 1 or 2, wherein a first separation distance between the first gate structures (160a) in the first direction (X) is equal to a second separation distance between the second gate structures (160b) in the first direction (X).

4. The semiconductor device of any one of claims 1 to 3, wherein each of the first gate structures (160a) and each of the second gate structures (160b) comprises a gate electrode (165) and a gate spacer layer (164) on a side surface of the gate electrode (165), and
wherein the gate spacer layer (164) includes a same material as the first fin spacer (155a; 155a') and the second fin spacer (155b; 155b').

5. The semiconductor device of any one of claims 1 to 4, wherein the first source/drain region (150a; 150a') comprises a first extension portion (151a) extending in the third direction (Z) on the first active pattern (105a) and having a third width (W1a) in the second direction (Y), and a first expansion portion (152a; 152a') extending from the first extension portion (151a),
wherein the second source/drain region (150b; 150b') comprises a second extension portion (151b) extending in the third direction (Z) on the second active pattern (105b) and having a fourth width (W1b) in the second direction (Y) that is less than the third width (W1a), and a second expansion portion (152b; 152b') extending from the second extension portion (151b), and
wherein the first expansion portion (152a; 152a') and the second expansion portion (152b; 152b') each have a width in the second direction (Y) that increases and then decreases when moving in the third direction (Z) away from the substrate (101).

6. The semiconductor device of claim 5, wherein the first fin spacer (155a; 155a') is on a side surface of the first extension portion (151a), and a side surface of the first expansion portion (152a; 152a') is free of the first fin spacer (155a; 155a') thereon, and
wherein the second fin spacer (155b; 155b') is on a side surface of the second extension portion (151b), and a side surface of the second expansion portion (152b; 152b') is free of the second fin spacer (155b; 155b') thereon.

7. The semiconductor device of claim 5 or 6, further comprising a device isolation layer (110) on opposite sides of the first active pattern (105a) and opposite sides of the second active pattern (105b),
wherein the first fin spacer (155a) extends from a side surface of the first extension portion (151a) of the first source/drain region (150a; 150a') onto the device isolation layer (110), and
wherein the second fin spacer (155b) extends from a side surface of the second extension portion (151b) of the second source/drain region (150b; 150b') onto the device isolation layer (110).

8. The semiconductor device of claim 7, further comprising an interlayer insulating layer (170) on the first and second fin spacers (155a, 155b), the first expansion portion (152; 152a'), the second expansion portion (152b; 152b'), and the device isolation layer (110).

9. The semiconductor device of any one of claims 5 to 8, wherein a height of the first extension portion (151a) in the third direction (Z) is less than a height of the second extension portion (151b) in the third direction (Z).

10. The semiconductor device of any one of claims 5 to 9, wherein a fifth width (W1a) of the first extension portion (151a) of the first source/drain region (150a; 150a') in the second direction (Y) is greater than a sixth width (W1b) of the second extension portion (151b) of the second source/drain region (150b; 150b') in the second direction (Y).

11. The semiconductor device of any one of claims 5 to 10, wherein the width of the first expansion portion (152a; 152a') of the first source/drain region (150a; 150a') transitions from increasing to decreasing at a first point in the third direction (Z) when moving away from the substrate (101),
wherein the width of the second expansion portion (152b; 152b') of the second source/drain region (150b; 150b') transitions from increasing to decreasing at a second point in the third direction (Z) when moving away from the substrate (101), and
wherein the first point is lower than the second point in the third direction (Z), relative to an upper surface of the substrate (101).

12. The semiconductor device of any one of claims 1 to 11, further comprising:
another first fin spacer (155a; 155a') on the first source/drain region (150a; 150a') opposite the first fin spacer (155a; 155a'); and
another second fin spacer (155b; 155b') on the second source/drain region (150b; 150b') opposite the second fin spacer (155b; 155b'),
wherein a first distance (W1a) between the first fin spacer (155a; 155a') and the another first fin spacer (155a) in the second direction (Y) is greater than a second distance (W1b) between the second fin spacer (155b; 155b') and the another second fin spacer (155b; 155b') in the second direction (Y).

13. The semiconductor device of any one of claims 1 to 12, further comprising:
a first contact plug (180a) extending into an upper surface of the first source/drain region (150a; 150a') and electrically connected to the first source/drain region (150a; 150a'); and
a second contact plug (180b) extending into an upper surface of the second source/drain region (150b; 150b') and electrically connected to the second source/drain region (150b; 150b'),
wherein a first length of a lower surface of the first contact plug (180a) in the second direction (Y) is greater than a second length of a lower surface of the second contact plug (180b) in the second direction (Y).

14. The semiconductor device of any one of claims 1 to 13, wherein the first active pattern (105a) and the second active pattern (105b) are adjacent to each other in the first direction (X).

15. The semiconductor device of any one of claims 1 to 14, further comprising:
a first channel structure (140a) that comprises a plurality of first channel layers (141a-144a) spaced apart from each other in the third direction (Z) on the first active pattern (105a) and at least partially surrounded by a respective one of the first gate structures (160a); and
a second channel structure (140b) that comprises a plurality of second channel layers (141b-144b) spaced apart from each other in the third direction (Z) on the second active pattern (105b) and at least partially surrounded by a respective one of the second gate structures (160b),
wherein a lowermost one of the plurality of first channel layers (141a-144a) has a third width in the second direction (Y), and
wherein a lowermost one of the plurality of second channel layers (141b-144b) has a fourth width in the second direction (Y) that is less than the third width.
